# EUROPEAN PATENT APPLICATION

(11) **EP 1 970 940 A2**
(43) Date of publication of application: **17.09.2008**
(21) Application number: 08004857.2
(22) Date of filing: 14.03.2008
(51) Int. Cl.: H01L 21/00

(54) **Substrate processing apparatus, substrate processing method and storage medium**

(30) Priority: 16.03.2007 JP 2007068179
(71) Applicant: TOKYO ELECTRON LIMITED, Minato-ku Tokyo Tokyo 107-6325 (JP)
(72) Inventor: Onishi, Tadashi, Funabashi-shi, Chiba 273-0046 (JP)
(74) Representative: HOFFMANN EITLE

(57) **Abstract**

A substrate processing apparatus includes: a gas supply mechanism supplying gas containing a halogen element and basic gas into a process chamber; and a first temperature adjusting member and a second temperature adjusting member adjusting a temperature of the substrate in the process chamber, wherein the second temperature adjusting member adjusts the temperature of the substrate to a higher temperature than the first temperature adjusting member.

## Description

### Background of the Invention

### 1. Field of the Invention

The present invention relates to a substrate processing apparatus and a substrate processing method for removing an oxide film on a surface of a substrate by chemical processing and heat treatment.

### 2. Description of the Related Art

In manufacturing processes of semiconductor devices, for instance, various processing steps are performed while the inside of a process chamber housing a semiconductor wafer (hereinafter, referred to as a "wafer") is set in a low-pressure state close to a vacuum state. As an example of the processing utilizing such a low-pressure state, there has been known COR (Chemical Oxide Removal) processing for chemically removing an oxide film (silicon dioxide (SiO₂)) existing on a surface of a silicon wafer (see, the specification of US Patent Application Publication No. 2004/0182417 and the specification of US Patent Application Publication No. 2004/0184792). In this COR processing, under the low-pressure state, mixed gas of gas containing a halogen element and basic gas is supplied while the temperature of the wafer is adjusted to a predetermined value, thereby turning the oxide film into a reaction product mainly containing ammonium fluorosilicate, and then the reaction product is vaporized (sublimated) by heating to be removed from the wafer. In this case, hydrogen fluoride gas (HF) is used as the gas containing the halogen element, for instance, and ammonia gas (NH₃) is used as the basic gas, for instance.

### Summary of the Invention

As an apparatus for such COR processing, there has been generally known an apparatus including: a chemical processing chamber in which the step of turning an oxide film on a surface of a wafer into a reaction product is performed under a relatively low temperature; and a heat treatment chamber in which the step of removing the reaction product from the wafer by heating and sublimating the reaction product is performed under a relatively high temperature. However, such a processing apparatus in which the chemical processing chamber and the heat treatment chamber are separately provided has a disadvantage that the apparatus becomes large, leading to an increase in footprint since the number of process chambers increases. Further, separately providing the chemical processing chamber and the heat treatment chamber necessitates the transfer of a wafer therebetween, which requires a complicated carrier mechanism and further may cause a problem that during the transfer, the wafer is contaminated and contaminants are released from the wafer.

The present invention was made in view of the above and its object is to provide a substrate processing apparatus and a substrate processing method capable of performing chemical processing and heat treatment in the same process chamber.

To solve the above problems, according to the present invention, there is provided a substrate processing apparatus removing an oxide film on a surface of a substrate by chemical processing and heat treatment, the apparatus including: a gas supply mechanism supplying gas containing a halogen element and basic gas into a process chamber; and a first temperature adjusting member and a second temperature adjusting member adjusting a temperature of the substrate in the process chamber, wherein the second temperature adjusting member adjusts the temperature of the substrate to a higher temperature than the first temperature adjusting member.

In this substrate processing apparatus, the inside of the process chamber may be airtightly closable. The substrate processing apparatus may further include an exhaust mechanism exhausting the inside of the process chamber.

For example, the substrate processing apparatus further includes a support member supporting the substrate in the process chamber, wherein the second temperature adjusting member is thermally in contact with the support member, and the first temperature adjusting member is capable of thermally coming into contact with and separating from the support member. In this case, a rear surface of the support member may be exposed to an external part of the process chamber, and the first temperature adjusting member may be capable of thermally coming into contact with or separating from the rear surface of the support member, in the external part of the process chamber. Further, a rear surface of the support member may be covered by the second temperature adjusting member, and the first temperature adjusting member may come into contact with the second temperature adjusting member. Further, the second temperature adjusting member may be buried in the support member, and the first temperature adjusting member may come into contact with the support member. Further, for example, total heat capacity of the support member and the second temperature adjusting member is smaller than heat capacity of the first temperature adjusting member.

For example, in the substrate processing apparatus, the first temperature adjusting member is a mounting table on which the substrate is placed in the process chamber, and the apparatus further includes a lifter mechanism lifting up the substrate from the mounting table in the process chamber, wherein the temperature of the substrate which has been lifted up from the mounting table by the lifter mechanism is adjusted by the second temperature adjusting member. In this case, the substrate processing apparatus may further include: a partition member disposed around the substrate which has been lifted up from the mounting table by the lifter mechanism; a first exhaust mechanism exhausting the inside of the process chamber above the partition member; and a second exhaust mechanism exhausting the inside of the process chamber under the partition member. Further, the gas supply mechanism may supply the gas containing the halogen element and the basic gas to the inside of the process chamber above the substrate which has been lifted up from the mounting table by the lifter mechanism.

Further, according to the present invention, there is provided a substrate processing method of removing an oxide film on a surface of a substrate by chemical processing and heat treatment, the method including the steps of: supplying gas containing a halogen element and basic gas to the inside of a process chamber and adjusting a temperature of the substrate by a first temperature adjusting member, thereby turning the oxide film on the surface of the substrate into a reaction product; and adjusting the temperature of the substrate to a higher temperature by the second temperature adjusting member than the first temperature adjusting member, thereby vaporizing the reaction product. The inside of the process chamber may be exhausted.

In the substrate processing method, for example, the substrate may be supported by a support member including the second temperature adjusting member, and in the step of turning the oxide film on the surface of the substrate into the reaction product, the first temperature adjusting member may be brought into thermal contact with the support member, and in the step of vaporizing the reaction product, the first temperature adjusting member may be thermally separated from the support member. In this case, the first temperature adjusting member may be thermally brought into contact with or separated from the support member, in an external part of the process chamber. Further, for example, total heat capacity of the support member and the second temperature adjusting member is smaller than heat capacity of the first temperature adjusting member.

Further, in the substrate processing method, for example, in the step of turning the oxide film on the surface of the substrate into the reaction product, the temperature of the substrate is adjusted while the substrate is placed on a mounting table as the first temperature adjusting member, and in the step of vaporizing the reaction product, the temperature of the substrate may be adjusted by the second temperature adjusting member while the substrate is lifted up from the mounting table in the process chamber.

Further, according to the present invention, there is provided a storage medium containing a recorded program executable by a control unit of a substrate processing apparatus, the program causing the substrate processing apparatus to perform the above substrate processing method when executed by the control unit.

According to the present invention, since it is possible to remove the oxide film on the surface of the substrate by the chemical processing and the heat treatment in the same process chamber, the substrate processing apparatus can be compact and a complicated transfer sequence for substrate transfer is not required. Further, the processing time can be shortened, which can improve a throughput. Further, since the temperature of the substrate is adjusted by the first temperature adjusting member and the second temperature adjusting member, it is possible to rapidly heat and cool the substrate.

### Brief Description of the Drawings

FIG. 1 is a plane view showing a rough configuration of a processing system;
FIG. 2 is an explanatory view of a COR apparatus according to a first embodiment of the present invention, showing a state where a cooling block is raised;
FIG. 3 is an explanatory view of the COR apparatus according to the first embodiment of the present invention, showing a state where the cooling block is lowered;
FIG. 4 is an explanatory view of a lifter mechanism;
FIG. 5 is an enlarged partial sectional view showing the structure for attaching a peripheral edge portion of a face plate to an upper surface of a base portion;
FIG. 6 is an enlarged partial sectional view showing the structure for attaching the peripheral edge portion of the face plate, which is different from the structure in FIG. 5;
FIG. 7 is a vertical sectional view used to explain the cooling block;
FIG. 8 is a rough vertical sectional view showing the structure of a surface of a wafer before a Si layer is etched;
FIG. 9 is a rough vertical sectional view showing the structure of the surface of the wafer after the Si layer is etched;
FIG. 10 is a rough vertical sectional view showing a state of the surface of the wafer after the wafer undergoes COR processing;
FIG. 11 is a rough vertical sectional view showing a state of the surface of the wafer after the wafer undergoes film forming processing for forming a SiGe layer;
FIG. 12 is an explanatory view of a COR apparatus according to a second embodiment of the present invention, showing a state where a wafer is placed on a mounting table (first processing position);
FIG. 13 is an explanatory view of the COR apparatus according to the second embodiment of the present invention, showing a state where the wafer is lifted up from the mounting table (second processing position); and
FIG. 14 is an explanatory view of a face plate with whose lower surface a cooling block comes into direct contact.

### Detailed Description of the Invention

Hereinafter, embodiments of the present invention will be described, taking a case in which an oxide film (silicon dioxide (SiO₂)) formed on a surface of a silicon wafer (hereinafter, referred to as a "wafer") is removed by COR processing, as an example of a method and an apparatus for removing an oxide film on a surface of a substrate by chemical processing and heat treatment. In the specification and drawings, constituent elements having substantially the same functions and structures are denoted by the same reference numerals and symbols, and redundant description thereof will be omitted.

### (Overall Description of Processing System 1)

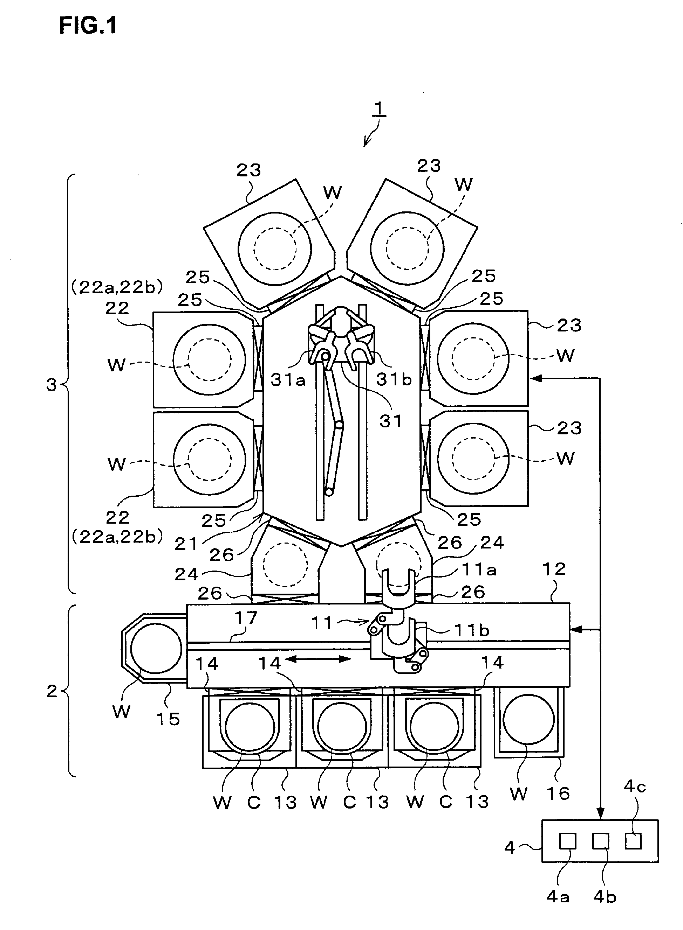

FIG. 1 is a plane view showing a rough configuration of a processing system 1 including COR apparatuses 22. The COR apparatus 22 is a COR apparatus 22a according to a first embodiment of the present invention or a COR apparatus 22b according to a second embodiment of the present invention which will be described later. The processing system 1 is configured to apply COR (Chemical Oxide Removal) processing and film forming processing to a wafer W. In the COR processing, a chemical processing step to turn a natural oxide film (silicon dioxide (SiO₂)) on a surface of the wafer W into a reaction product and a heat treatment step to heat and sublimate the reaction product are performed. In the chemical processing step, gas containing a halogen element and basic gas are supplied as process gases to the wafer W, thereby causing a chemical reaction of the natural oxide film on the surface of the wafer W and gas molecules of the process gases, so that the reaction product is produced. The gas containing the halogen element is, for example, hydrogen fluoride gas and the basic gas is, for example, ammonia gas. In this case, the reaction product mainly containing ammonia fluorosilicate is produced. The heat treatment step is a PHT (Post Heat Treatment) step to heat the wafer W having undergone the chemical processing to vaporize the reaction product, thereby removing the reaction product from the wafer. In the film forming processing, a film of SiGe or the like, for instance, is epitaxially grown on the surface of the wafer W from which the natural oxide film has been removed.

The processing system 1 shown in FIG. 1 includes: a load/unload unit 2 loading/unloading the wafer W to/from the processing system 1; a processing unit 3 applying the COR processing and the film forming processing to the wafer W; and a control unit 4 controlling the load/unload unit 2 and the processing unit 3.

The load/unload unit 2 has a carrier chamber 12 in which a first wafer carrier mechanism 11 carrying the wafer W in a substantially disk shape is provided. The wafer carrier mechanism 11 has two carrier arms 11a, 11b each holding the wafer W in a substantially horizontal state. On a side of the carrier chamber 12, there are, for example, three mounting tables 13 on which carriers C each capable of housing the plural wafers W are mounted. In each of the carriers C, the maximum of, for example, 25 pieces of the wafers W can be horizontally housed in multi tiers at equal pitches, and the inside of the carriers C is filled with an N₂ gas atmosphere, for instance. Between the carriers C and the carrier chamber 12, gate valves 14 are disposed, and the wafer W is transferred between the carriers C and the carrier chamber 12 via the gate valves 14. On sides of the mounting tables 13, provided are: an orienter 15 which rotates the wafer W and optically calculates its eccentricity amount to align the wafer W; and a particle monitor 16 measuring an amount of particles of extraneous matters and the like adhering on the wafer W. In the carrier chamber 12, a rail 17 is provided, and the wafer carrier mechanism 11 is capable of approaching the carriers C, the orienter 15, and the particle monitor 16 by moving along the rail 17.

In the load/unload unit 2, the wafer W is horizontally held by either of the carrier arms 11a, 11b of the wafer carrier mechanism 11, and when the wafer carrier mechanism 11 is driven, the wafer W is rotated and moved straight in a substantially horizontal plane or lifted up/down. Consequently, the wafer W is carried to/from the carriers C, the orienter 15, and the particle monitor 16 from/to later-described two load lock chamber 24.

At the center of the processing unit 3, a common carrier chamber 21 formed in a substantially polygonal shape (for example, a hexagonal shape) is provided. In the shown example, two COR apparatuses 22 (the COR apparatuses 22a according to the first embodiment of the present invention or the COR apparatuses 22b according to the second embodiment of the present invention) applying the COR processing to the wafer W, four epitaxial growth apparatuses 23 applying the SiGe layer film forming processing to the wafer W, and the two load lock chambers 24 which can be evacuated are provided around the common carrier chamber 21. Between the common carrier chamber 21 and the COR apparatuses 22 and between the common carrier chamber 21 and the epitaxial growth apparatuses 23, openable/closable gate vales 25 are provided respectively.

The two load lock chambers 24 are disposed between the carrier chamber 12 of the load/unload unit 2 and the common carrier chamber 21 of the processing unit 3, and the carrier chamber 12 of the load/unload unit 2 and the common carrier chamber 21 of the processing unit 3 are coupled to each other via the two load lock chambers 24. Openable/closable gate valves 26 are provided between the load lock chambers 24 and the carrier chamber 12 and between the load lock chambers 24 and the common carrier chamber 21. One of the two load lock chambers 24 may be used when the wafer W is carried out of the carrier chamber 12 to be carried into the common carrier chamber 21, and the other may be used when the wafer W is carried out of the common carrier chamber 21 to be carried into the carrier chamber 12.

A second wafer carrier mechanism 31 carrying the wafer W is provided in the common carrier chamber 21. The wafer carrier mechanism 31 has two carrier arms 31a, 31b each holding the wafer W in a substantially horizontal state.

In such a common carrier chamber 21, the wafer W is horizontally held by either of the carrier arms 31a, 31b, and when the wafer carrier mechanism 31 is driven, the wafer W is rotated and moved straight in a substantially horizontal plane or lifted up/down to be carried to a desired position. Then, by the carrier arms 31a, 31b entering and exiting from the load lock chambers 24, the COR apparatuses 22, and the epitaxial growth apparatuses 23, the wafers W are loaded/unloaded thereto/therefrom.

### (Structure of COR Apparatus 22a according to First Embodiment)

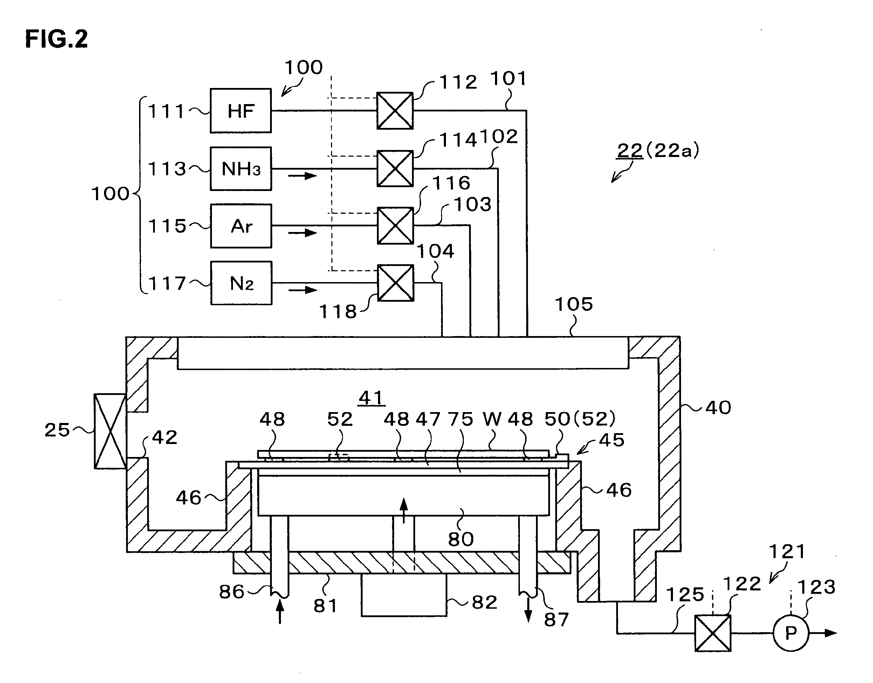

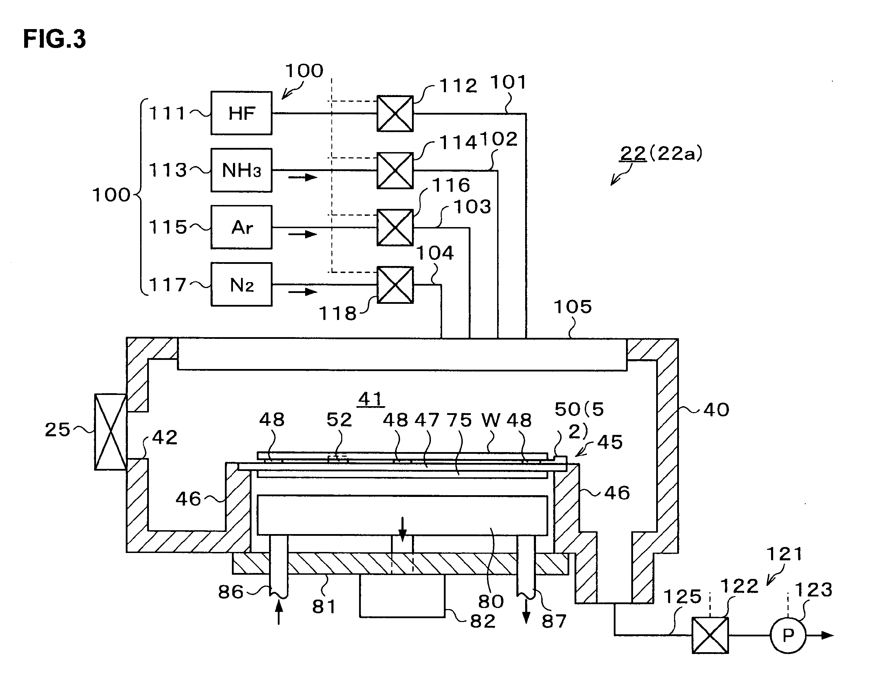

FIG. 2 and FIG. 3 are explanatory views of the COR apparatus 22a according to the first embodiment of the present invention. FIG 2 shows a state where a cooling block 80 is raised. FIG. 3 shows a state where the cooling block 80 is lowered.

The COR apparatus 22a includes a casing 40, and the inside of the casing 40 is an airtight process chamber (processing space) 41 housing the wafer W. The casing 40 is made of metal such as aluminum (Al) or an aluminum alloy which has been surface-treated, for instance, anodized. The casing 40 has on its one side surface a load/unload port 42 through which the wafer W is loaded/unloaded to/from the process chamber 41, and the aforesaid gate valve 25 is provided on the load/unload port 42.

In the process chamber 41, a mounting table 45 is provided to have the wafer W placed thereon in a substantially horizontal state. The mounting table 45 is structured such that a face plate 47 as a support member supporting the wafer W is horizontally attached on an upper surface of a cylindrical base portion 46 formed on a bottom surface of the casing 40. The face plate 47 is in a disk shape slightly larger than the wafer W. Further, the face plate 47 is made of a material excellent in heat transfer property, and is made of, for example, SiC or AIN.

On an upper surface of the mounting table 45 (an upper surface of the face plate 47), a plurality of abutting pins 48 as abutting members abutting on a lower surface of the wafer W are provided so as to protrude upward. The abutting pins 48 are made of the same material as that of the face plate 47 or made of ceramics, resin, or the like. The wafer W is supported substantially horizontally on the upper surface of the mounting table 45 while a plurality of points of its lower surface are set on upper end portions of the abutting pins 48 respectively.

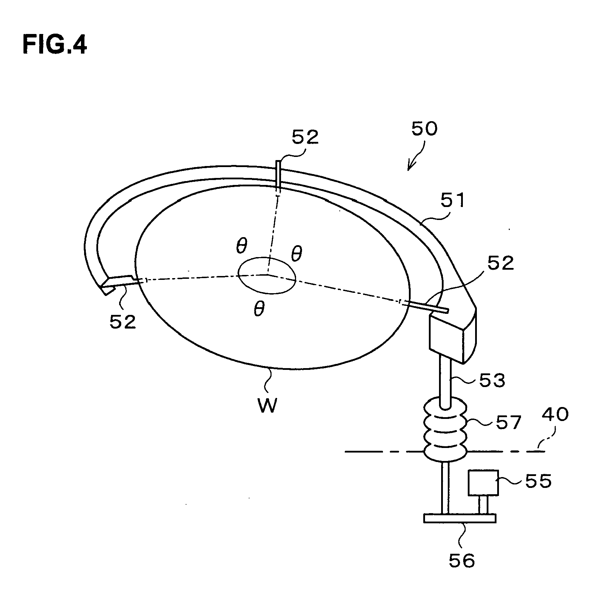

Further, around the wafer W, a lifter mechanism 50 is provided to place the wafer W carried into the process chamber 41 on the upper surface of the mounting table 45 (the upper surface of the face plate 47) and lift up the wafer W placed on the upper surface of the mounting table from the mounting table 45. As shown in FIG. 4, the lifter mechanism 50 is structured such that three lifter pins 52 are attached to an inner side of a support member 51 in a substantially C shape disposed outside the wafer W In FIG. 2 and FIG. 3, only the lifter pins 52 of the lifter mechanism 50 are shown.

As shown in FIG. 4, the three lifter pins 52 support a lower surface of a peripheral edge portion of the wafer W, and lines connecting positions at which the lifter pins 52 support the wafer W form an isosceles triangle (including an equilateral triangle). In a case where the lines connecting the positions at which the lifter pins 52 support the wafer W form an equilateral triangle as an example, each center angle θ made by the lifter pins 52 is 120°. The support member 51 is attached to an upper end of a lifter rod 53 penetrating through the bottom surface of the casing 40. A lifter device 55 such as a cylinder disposed outside the process chamber 41 is attached to a lower end of the lifter rod 53 via a bracket 56. Further, around the lifter rod 53, a bellows 57 is provided to allow the upward and downward movement of the lifter rod 53 while keeping the inside of the process chamber 41 airtight.

The lifer mechanism 50 as structured above is capable of lifting up/down the wafer W supported by the lifter pins 52 in the process chamber 41 when the lifter device 55 is operated. When the wafer W is carried into the COR apparatus 22a by either of the carrier arms 31a, 31b of the aforesaid wafer carrier mechanism 31, the lifter pins 52 of the lifter mechanism 50 move up to receive the wafer W from the carrier arm 31a, 31b, and thereafter, the lifter pins 52 move down to place the wafer W on the upper surface of the mounting table 45 (the upper surface of the face plate 47). Further, when the wafer W is to be carried out of the COR apparatus 22a, the lifter pins 52 first move up, so that the wafer W is lifted up to a position above the mounting table 45 Thereafter, either of the carrier arms 31a, 31b of the aforesaid wafer carrier mechanism 31 receives the wafer W from the lifter pins 55 to carry the wafer W out of the COR apparatus 22a.

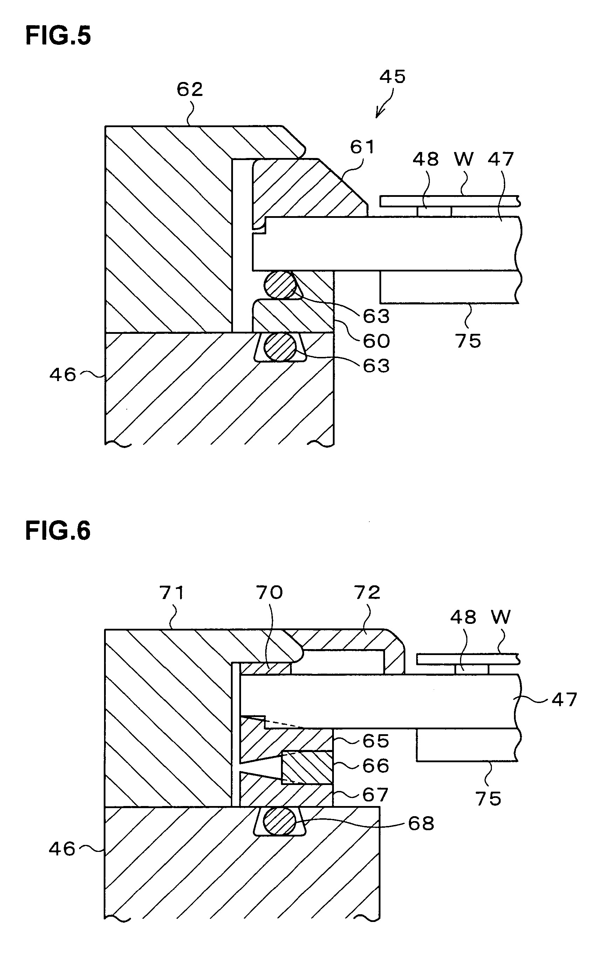

FIG. 5 is an enlarged partial sectional view showing the structure for attaching a peripheral edge portion of the face plate 47 to the upper surface of the base portion 46. A heat insulating member 60 in a ring shape such as, for example, VESPEL (registered trademark) is disposed between the upper surface of the base portion 46 and a lower surface of the peripheral edge portion of the face plate 47. Further, on an upper surface of the peripheral edge portion of the face plate 47, a heat insulating member 61 in a ring shape such as, for example, VESPEL (registered trademark) is similarly disposed, and the face plate 47 is further pressed by a fixing member 62 from above the insulating member 61, so that the face plate 47 is fixed to the upper surface of the base portion 46. The heat insulating members 60, 61 are thus disposed between the peripheral edge portion of the face plate 47 and the upper surface of the base portion 46 to thermally insulate the peripheral edge portion of the face plate 47 and the upper surface of the base portion 46 from each other.

Sealing members 63 such as O-rings are disposed between the lower surface of the peripheral edge portion of the face plate 47 and the heat insulating member 60 and between the heat insulating member 60 and the upper surface of the base portion 46. Therefore, the inside of the process chamber 41, that is, an area above the face plate 47, is kept airtightly closed relative to the outside of the process chamber 41, that is, an area under the face plate 47. On the other hand, the rear surface (lower surface) of the face plate 47 is exposed to the outside of the process chamber 41 via the inside of the base portion 46.

FIG. 6 is an enlarged partial sectional view showing the structure for attaching the peripheral edge portion of the face plate 47, which is different from the structure in FIG. 5. In this attachment structure in FIG. 6, an upper gasket 65 in a ring shape, a heat insulating member 66 in a ring shape such as, for example, VESPEL (registered trademark), and a lower gasket 67 in a ring shape are disposed between the lower surface of the peripheral edge portion of the face plate 47 and the upper surface of the base portion 46. A gap between the peripheral edge portion of the face plate 47 and the upper gasket 65, a gap between the upper gasket 65 and the heat insulating member 66, and a gap between the heat insulating member 66 and the lower gasket 67 are all sealed by metal sealing structures. A sealing member 68 such as an O-ring is provided between the lower gasket 67 and the upper surface of the base portion 46. Therefore, the inside of the process chamber 41, that is, an area above the face plate 47, is kept airtightly closed relative to the outside of the process chamber 41, that is, an area under the face plate 47.

A heat insulating member 70 in a ring shape such as, for example, VESPEL (registered trademark) is further disposed on the upper surface of the peripheral edge portion of the face plate 47, and the face plate 47 is further pressed from above the heat insulating member 70, so that the face plate 47 is fixed to the upper surface of the base portion 46. In the attachment structure in FIG. 6, a focus ring 72 is disposed around the wafer W placed on the face plate 47. The attachment structure in FIG 6 can also maintain the heat insulation state between the peripheral edge portion of the face plate 47 and the upper surface of the base portion 46 while keeping the inside of the process chamber 41 airtight.

As shown in FIG. 2 and FIG. 3, a heater 75 as a second temperature adjusting member is provided in close contact with a rear surface (lower surface) of the face plate 47. The heater 75 is made of a material having an excellent heat transfer property and generating heat when supplied with electricity, and is made of, for example, SiC. By the heat generated from the heater 75, it is possible to heat the wafer W placed on the upper surface of the face plate 47. The heater 75 has a disk shape substantially equal in diameter to the wafer W, and by transferring the heat of the heater 75 to the whole wafer W via the face plate 47, it is possible to heat the whole wafer W uniformly.

The cooling block 80 as a first temperature adjusting member is disposed under the heater 75. The cooling block 80 is disposed on a rear surface (lower surface) side of the face plate 47, that is, outside the process chamber 41. The cooling block 80 is movable up/down by the operation of a lifter device 82 such as a cylinder supported by a bracket 81 fixed to a lower surface of the casing 40, and a state where the cooling block 80 is moved up to be in contact with the lower surface of the heater 75 (a state where the cooling block 80 is in thermal contact with the face plate 47) as shown in FIG. 2 and a state where the cooling block 80 is moved down to be separated from the lower surface of the heater 75 (a state where the face plate 47 is thermally separated from the face plate 47) as shown in FIG. 3 are switched. The cooling block 80 has a columnar shape substantially equal in diameter to the wafer W, and the whole upper surface of the cooling block 80 comes into contact with the rear surface of the heater 75 when the cooling block 80 is moved up as shown in FIG. 2.

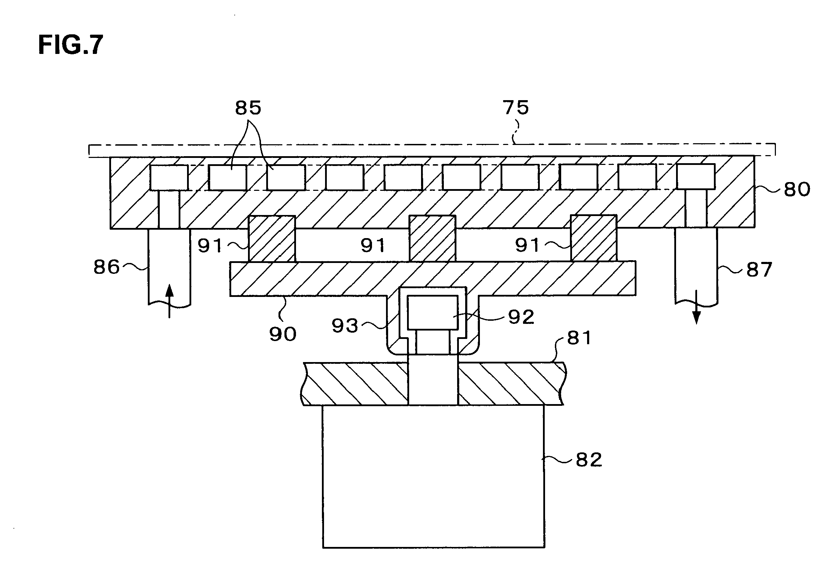

As shown in FIG. 7, a refrigerant channel 85 through which a refrigerant, for example, a fluorine-based inert chemical solution (Galden) flows is provided in the cooling block 80. By circulatingly supplying the refrigerant to the refrigerant channel 85 from the outside of the casing 40 through a refrigerant feed pipe 86 and a refrigerant drain pipe 87, it is possible to cool the cooling block 80 to about 25°C, for instance. The refrigerant feed pipe 86 and the refrigerant drain pipe 87 are formed of bellows, flexible tubes, or the like so that the feeding of the refrigerant is not prevented when the cooling block 80 moves up/down by the operation of the aforesaid lifter device 82.

A cushion plate 90 for bringing the cooling block 80 into close contact with the lower surface of the heater 75 is provided between the cooling block 80 and the lifter device 82. Specifically, as shown in FIG 7, a plurality of coil springs 91 are provided between the lower surface of the cooling block 80 and an upper surface of the cushion plate 90, and the cooling block 80 can be inclined in a desired direction relative to the cushion plate 90. Further, a lower surface of the cushion plate 90 is connected to a piston rod 92 of the lifter device 82 via a floating joint 93, so that the cushion plate 90 itself can also be inclined in a desired direction relative to the piston rod 92. With this structure, when the cooling block 80 is moved up by the operation of the lifter device 82 as shown in FIG. 2, the upper surface of the cooling block 80 comes into close contact with the whole lower surface of the heater 75. By thus bringing the cooling block 80 into close contact with the lower surface of the heater 75, it is possible to rapidly cool the wafer W placed on the upper surface of the face plate 47. The cooling block 80 has a disk shape substantially equal in diameter to the wafer W, and by transferring the cold heat of the cooling block 80 to the whole wafer W via the heater 75 and the face plate 47, it is possible to cool the whole wafer W uniformly.

Total heat capacity of the face plate 47 and the heater 75 is set smaller than heat capacity of the cooling block 80. Specifically, the aforesaid face plate 47 and heater 75 each have, for example, a thin plate shape with relatively small heat capacity and are made of a material excellent in heat transfer property such as SiC. On the other hand, the cooling block 80 has a columnar shape whose thickness is sufficiently larger than the total thickness of the face plate 47 and the heater 75. Therefore, in the state where the cooling block 80 is moved up to be in contact with the lower surface of the heater 75 as shown in FIG. 2, it is possible to rapidly cool the face plate 47 and the heater 75 by transferring the heat of the cooling block 80 to the face plate 47 and the heater 75. This enables rapid cooling of the wafer W placed on the upper surface of the face plate 47. On the other hand, in the state where the cooling block 80 is moved down to be separated from the lower surface of the heater 75 as shown in FIG 3, the face plate 47 and the heater 75 can be heated when the heater 75 is supplied with electricity. In this case, the face plate 47 and the heater 75 can be rapidly heated to a predetermined temperature owing to their relatively small heat capacity, which enables rapid heating of the wafer W placed on the upper surface of the face plate 47.

As shown in FIG. 2 and FIG. 3, the COR apparatus 22a has a gas supply mechanism 100 supplying predetermined gases into the process chamber 41. The gas supply mechanism 100 includes an HF supply path 101 through which hydrogen fluoride gas (HF) as the process gas containing the halogen element is supplied into the process chamber 41, an NH₃ supply path 102 through which ammonia gas (NH₃) as the basic gas is supplied into the process chamber 41, an Ar supply path 103 through which argon gas (Ar) as inert gas is supplied into the process chamber 41, an N₂ supply path 104 through which nitrogen gas (N₂) as inert gas is supplied into the process chamber 41, and a showerhead 105. The HF supply path 101 is connected to a supply source 111 of the hydrogen fluoride gas. Further, the HF supply path 101 has in its middle a flow rate regulating valve 112 capable of opening/closing the HF supply path 101 and adjusting a supply flow rate of the hydrogen fluoride gas. The NH₃ supply path 102 is connected to a supply source 113 of the ammonia gas. Further, the NH₃ supply path 102 has in its middle a flow rate regulating valve 114 capable of opening/closing the NH₃ supply path 102 and adjusting a supply flow rate of the ammonia gas. The Ar supply path 103 is connected to a supply source 115 of the argon gas. Further, the Ar supply path 103 has in its middle a flow rate regulating valve 116 capable of opening/closing the Ar supply path 103 and adjusting a supply flow rate of the argon gas. The N₂ supply path 104 is connected to a supply source 117 of the nitrogen gas. Further, the N₂ supply path 104 has in its middle a flow rate regulating valve 118 capable of opening/closing the N₂ supply path 104 and adjusting a supply flow rate of the nitrogen gas. The supply paths 101, 102, 103, 104 are connected to the showerhead 105 provided in a ceiling portion of the process chamber 41, and the hydrogen fluoride gas, the ammonia gas, the argon gas, and the nitrogen gas are diffusively jetted from the showerhead 105 into the process chamber 41.

In the COR apparatus 22a, an exhaust mechanism 121 exhausting the gas out of the process chamber 41 is provided. The exhaust mechanism 121 includes an exhaust path 125 having in its middle an opening/closing valve 122 and an exhaust pump 123 for forced exhaust.

### (Control Unit 4)

The functional elements of the processing system 1 and the COR apparatuses 22a are connected via signal lines to the control unit 4 automatically controlling the operation of the whole processing system 1. Here, the functional elements refer to all the elements which operate for realizing predetermined process conditions, such as, for example, the first wafer carrier mechanism 11, the gate valves 14, 25, 26, and the second wafer carrier mechanism 31 which are provided in the processing system 1, and the lifter mechanism 50, the heater 75, the lifter device 82, refrigerant supply to the cooling block 80, the gas supply mechanism 100, the exhaust mechanism 121, and so on which are provided in the COR apparatus 22a. The control unit 4 is typically a general-purpose computer capable of realizing an arbitrary function depending on software that it executes.

As shown in FIG. 1, the control unit 4 has an arithmetic part 4a including a CPU (central processing unit), an input/output part 4b connected to the arithmetic part 4a, and a storage medium 4c storing control software and inserted in the input/output part 4b. The control software (program) recorded in the storage medium 4c causes the processing system 1 and the COR apparatus 22a to perform a predetermined substrate processing method to be described later when executed by the control unit 4. By executing the control software, the control unit 4 controls the functional elements of the processing system 1 and the COR apparatus 22a so that various process conditions (for example, pressure of the process chamber 41 and so on) defined by a predetermined process recipe are realized.

The storage medium 4c may be the one fixedly provided in the control unit 4, or may be the one removably inserted in a not-shown reader provided in the control unit 4 and readable by the reader. In the most typical embodiment, the storage medium 4c is a hard disk drive in which the control software has been installed by a serviceman of a maker of the processing system 1. In another embodiment, the storage medium 4c is a removable disk such as CD-ROM or DVD-ROM in which the control software is written. Such a removable disk is read by an optical reader (not shown) provided in the control unit 4. Further, the storage medium 4c may be either of a RAM (random access memory) type or a ROM (read only memory) type. Further, the storage medium 4c may be a cassette-type ROM. In short, any medium known in a computer technical field is usable as the storage medium 4c. In a factory where the plural processing systems 1 are disposed, the control software may be stored in a management computer centrally controlling the control units 4 of the processing systems 1. In this case, each of the processing systems 1 is operated by the management computer via a communication line to execute a predetermined process.

### (Processing of Wafer W in Processing System 1 Including COR Apparatus 22a according to First Embodiment)

Next, a method of processing the wafer W using the processing system 1 including the COR apparatus 22a according to the first embodiment of the present invention will be described. To begin with, the structure of the wafer W will be described. The following will describe a case, as an example, where natural oxide films 156 formed on the surface of the wafer W having undergone an etching process are removed by the COR processing, and SiGe is epitaxially grown on a surface of a Si layer 150. It should be noted that the structure of the wafer W and the processing of the wafer W described below are only an example, and the present invention is not limited to the embodiment below.

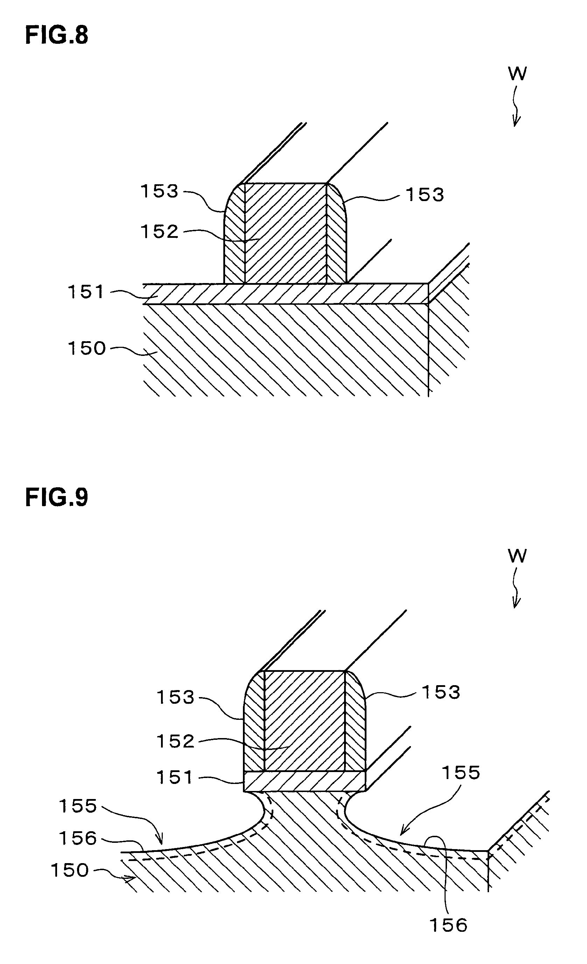

FIG. 8 is a rough sectional view of the wafer W which has not yet undergone the etching process, showing part of the surface of the wafer W (device formation surface). The wafer W is, for example, a thin-plate silicon wafer formed in a substantially disk shape, and on the surface of the wafer W, formed is a structure composed of the Si (silicon) layer 150 as a base material of the wafer W, an oxide layer (silicon dioxide: SiO₂) 151 used as an interlayer insulation layer, a Poly-Si (polycrystalline silicon) layer 152 used as a gate electrode, and, for example, TEOS (tetraethylorthosiicate: Si(OC₂H₅)₄) layers 153 as sidewall portions made of an insulator. A surface (upper surface) of the Si layer 150 is substantially flat, and the oxide layer 151 is stacked to cover the surface of the Si layer 150. Further, the oxide layer 151 is formed in, for example, a diffusion furnace through a thermal CVD reaction. The Poly-Si layer 152 is formed on a surface of the oxide layer 151 and is etched along a predetermined pattern shape. Therefore, some portions of the oxide layer 151 are covered by the Poly-Si layer 152, and other portions thereof are exposed. The TEOS layers 153 are formed to cover side surfaces of the Poly-Si layer 152. In the shown example, the Poly-Si layer 152 has a substantially prismatic cross section and is formed in a long and thin plate shape extending in a direction from the near side toward the far side in FIG. 8, and the TEOS layers 153 are provided on the right and left side surfaces of the Poly-Si layer 12 to extend along the direction from the near side toward the far side and to cover the Poly-Si layer 152 from its lower edge to upper edge. On the right and left sides of the Poly-Si layer 152 and the TEOS layers 153, the surface of the oxide layer 151 is exposed.

FIG. 9 shows a state of the wafer W having undergone the etching process. After the oxide layer 151, the Poly-Si layer 152, the TEOS layers 153, and so on are formed on the Si layer 150 as shown in FIG. 8, the wafer W is subjected to, for example, dry etching. Consequently, as shown in FIG 9, on the surface of the wafer W, the exposed oxide layer 151 and the Si layer 150 covered by the oxide layer 151 are partly removed. Specifically, on the right and left sides of the Poly-Si layer 152 and the TEOS layers 153, recessed portions 155 are formed respectively by the etching. The recessed portions 155 are formed so as to sink into the Si layer 150 from the height of the surface of the oxide layer 151, and the Si layer 150 is exposed on inner surfaces of the recessed portions 155. However, if oxygen in the atmosphere adheres to the surface of the Si layer 150 thus exposed in the recessed portions 155, the natural oxide films (silicon dioxide: SiO₂) 156 are formed on the inner surfaces of the recessed portions 155 since the Si layer 150 is easily oxidized.

The wafer W thus subjected to the etching process by a dry etching apparatus (not shown) or the like and having the natural oxide films 156 formed on the inner surfaces of the recessed portions 155 as shown in FIG. 9 is housed in the carrier C to be carried to the processing system 1.

In the processing system 1, as shown in FIG. 1, the carrier C housing the plural wafers W is placed on the mounting table 13, and one of the wafers W is taken out of the carrier C by the wafer carrier mechanism 11 to be carried into the load lock chamber 24. When the wafer W is carried into the load lock chamber 24, the load lock chamber 24 is airtightly closed and pressure-reduced. Thereafter, the load lock chamber 24 and the common carrier chamber 21 whose pressure is reduced below the atmospheric pressure are made to communicate with each other. Then, the wafer W is carried out of the load lock chamber 24 to be carried into the common carrier chamber 21 by the wafer carrier mechanism 31.

The wafer W carried into the common carrier chamber 21 is first carried into the process chamber 41 of the COR apparatus 22a. The wafer W is carried into the process chamber 41 of the COR apparatus 22a by either of the carrier arms 31a, 31b of the wafer carrier mechanism 31, with its surface (device formation surface) facing upward. Then, the lifter pins 52 of the lifter mechanism 50 move up and receive the wafer W. Thereafter, the lifter pins 52 move down to place the wafer W on the upper surface of the mounting table 45 (the upper surface of the face plate 47). After the carrier arm 31a, 31b exits from the inside of the process chamber 41, the load/unload port 42 is closed to make the inside of the process chamber 41 airtight. Incidentally, when the wafer W is thus carried into the process chamber 41, the pressure of the process chamber 41 has been reduced to a pressure close to vacuum.

Then, the cooling block 80 is moved up by the operation of the lifter device 82 as shown in FIG. 2 to bring the upper surface of the cooling block 80 into close contact with the whole lower surface of the heater.75. In this case, the cold heat of the cooling block 80 cooled in advance by the refrigerant which is circulatingly supplied to the refrigerant channel 85 is transferred to the face plate 47 and the heater 75, so that the face plate 47 and the heater 75 can be rapidly cooled since the total heat capacity of the face plate 47 and the heater 75 is smaller than the heat capacity of the cooling block 80. Consequently, the wafer W placed on the upper surface of the face plate 47 is cooled to, for example, about 25°C. Incidentally, in the state where the cooling block 80 is thus moved up, the heat generation of the heater 75 is not required.

Then, the hydrogen fluoride gas, the ammonia gas, the argon gas, and the nitrogen gas are supplied into the process chamber 41 through the respective supply paths 101, 102, 103, 104, followed by the chemical processing step for turning the natural oxide films 156 on the surface of the wafer W into the reaction products. In this case, through forced exhaust of the inside of the process chamber 41 by the exhaust mechanism 121, the pressure in the process chamber 41 is reduced to about 0.1 Torr (about 13.3 Pa) or lower, for instance. In such a low-pressure processing atmosphere, the natural oxide films 156 existing on the surface of the wafer W chemically react with molecules of the hydrogen fluoride gas and molecules of the ammonia gas to be turned into the reaction products.

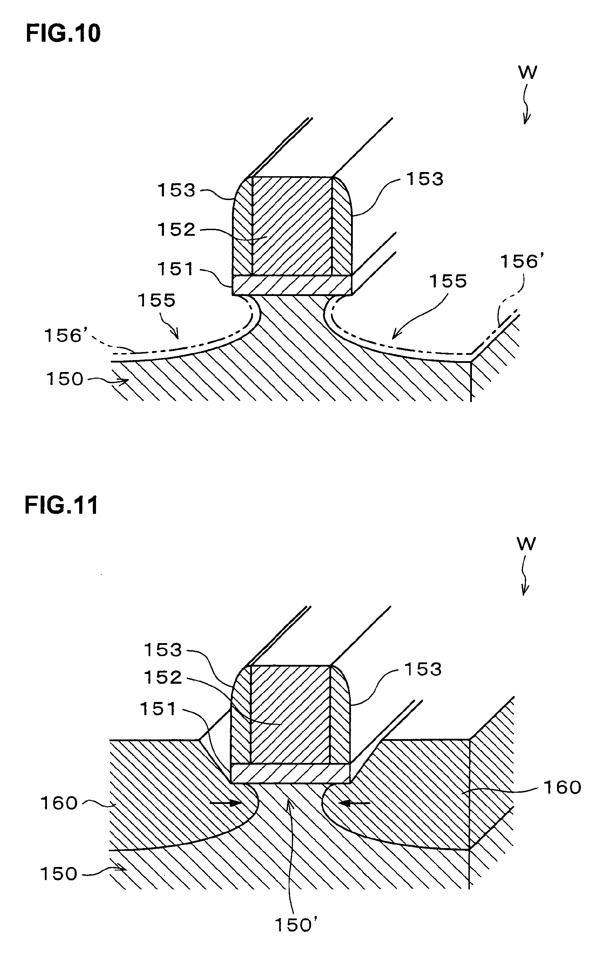

When the chemical processing step is finished, the PHT step (heat treatment step) is started. In the heat treatment step, the cooling block 80 is moved down by the operation of the lifter device 82 as shown in FIG. 3 to be separated from the lower surface of the heater 75. Then, by the electricity supply to the heater 75, the face plate 47 and the heater 75 are heated to, for example, about 100°C or higher. In this case, the face plate 47 and the heater 75 can be rapidly heated to the target temperature owing to their relatively small heat capacity, which enables rapid heating of the wafer W placed on the upper surface of the face plate 47. Further, the inside of the process chamber 41 is forcedly exhausted by the exhaust mechanism 121 along with the supply of the argon gas and the nitrogen gas into the process chamber 41 through the respective supply paths 103, 104, and reaction products 156' produced by the above chemical processing step are heated and vaporized to be removed from the inner surfaces of the recessed portions 155. Through the above processes, the surface of the Si layer 150 is exposed (see FIG. 10). Such a heat treatment step following the chemical processing step makes it possible to dry-clean the wafer W and remove the natural oxide films 156 from the Si layer 150 by dry etching.

When the COR processing including the chemical processing step and the heat treatment step is thus finished, the supply of the argon gas and the nitrogen gas is stopped and the load/unload port 42 (gate valve 25) of the COR apparatus 22a is opened. Thereafter, the wafer W is carried out of the process chamber 41 by the wafer carrier mechanism 31 to be carried into the epitaxial growth apparatus 23..

When the wafer W with the surface of the Si layer 150 being exposed by the COR processing is thus carried into the epitaxial growth apparatus 23, the SiGe film forming processing step is then started. In the film forming processing step, reaction gas supplied to the epitaxial growth apparatus 23 and the Si layer 150 exposed in the recessed portions 155 of the wafer W chemically react with each other, so that SiGe layers 160 are epitaxially grown on the recessed portions 155 (see FIG. 11). Here, since the natural oxide films 156 have been removed by the aforesaid COR processing from the surface of the Si layer 150 exposed in the recessed portions 155, the SiGe layers 160 are suitably grown with the surface of the Si layer 150 serving as their base.

When the SiGe layers 160 are thus formed on the recessed portions 155 on the both sides, a portion of the Si layer 150 sandwiched by the SiGe layers 160 is given a compressive stress from both sides. That is, under the Poly-Si layer 152 and the oxide layer 151, a strained Si layer 150' having a compressive strain is formed in the portion sandwiched by the SiGe layers 160.

When the SiGe layers 160 are thus formed, that is, when the film forming processing step is finished, the wafer W is carried out of the epitaxial growth apparatus 23 by the wafer carrier mechanism 31 to be carried into the load lock chamber 24. When the wafer W is carried into the load lock chamber 24, the load lock chamber 24 is airtightly closed and thereafter the load lock chamber 24 and the carrier chamber 12 are made to communicate with each other. Then, the wafer W is carried out of the load lock chamber 24 to be returned to the carrier C on the mounting table 13 by the wafer carrier mechanism 11. In the above-described manner, a series of processes in the processing system 1 is finished.

In such a COR apparatus 22a according to the first embodiment of the present invention, it is possible to rapidly cool the wafer W placed on the upper surface of the face plate 47 by bringing the cooling block 80 as the first temperature adjusting member into thermal contact with the face plate 47 as the support member. Further, when the cooling block 80 is separated from the face plate 47, the wafer W placed on the upper surface of the face plate 47 can be rapidly heated by the heat generated from the heater 75 as the second temperature adjusting member. This enables rapid heat treatment of the wafer W, which can shorten the processing time to improve a throughput. Further, since the wafer W can be COR-processed in the same process chamber 41, the COR apparatus 22a can be compact and a complicated transfer sequence for transferring the wafer W is not required.

Further, since the cooling block 80 is disposed outside the pressure-reduced process chamber 41 and comes into thermal contact with the rear surface (lower surface) side of the face plate 47, the cooling block 80 is prevented from coming into a so-called vacuum heat insulation state and thus is capable of efficiently cooling the face plate 47. In this case, since the cooling block 80 is supported via the cushion plate 90 and the coil springs 91, the whole upper surface of the cooling block 80 can be in contact with the rear surface of the heater 75, which makes it possible to cool the whole face plate 47 to uniformly cool the wafer W.

### (Structure of COR Apparatus 22b according to Second Embodiment)

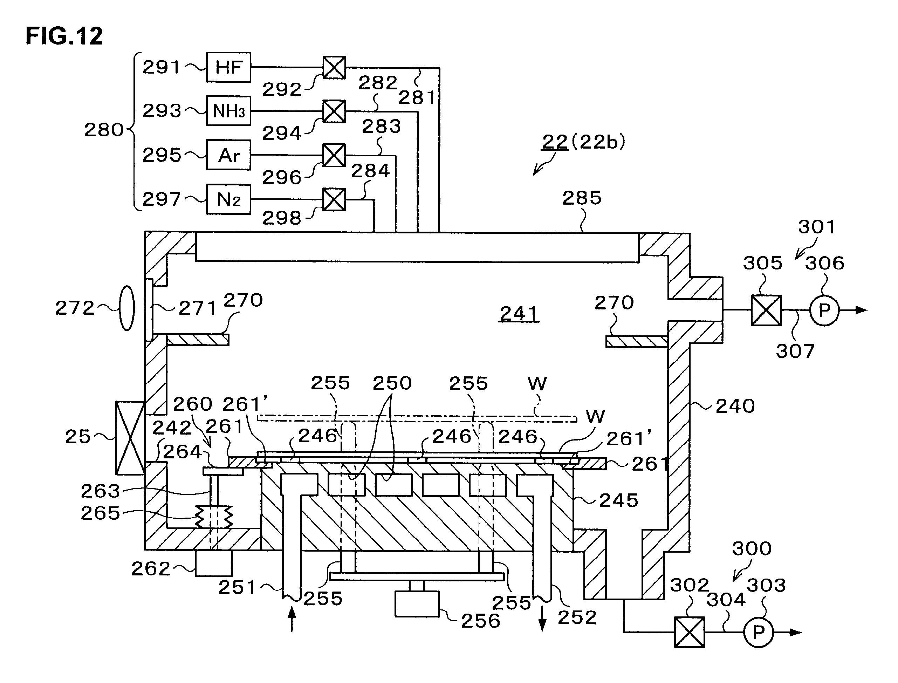

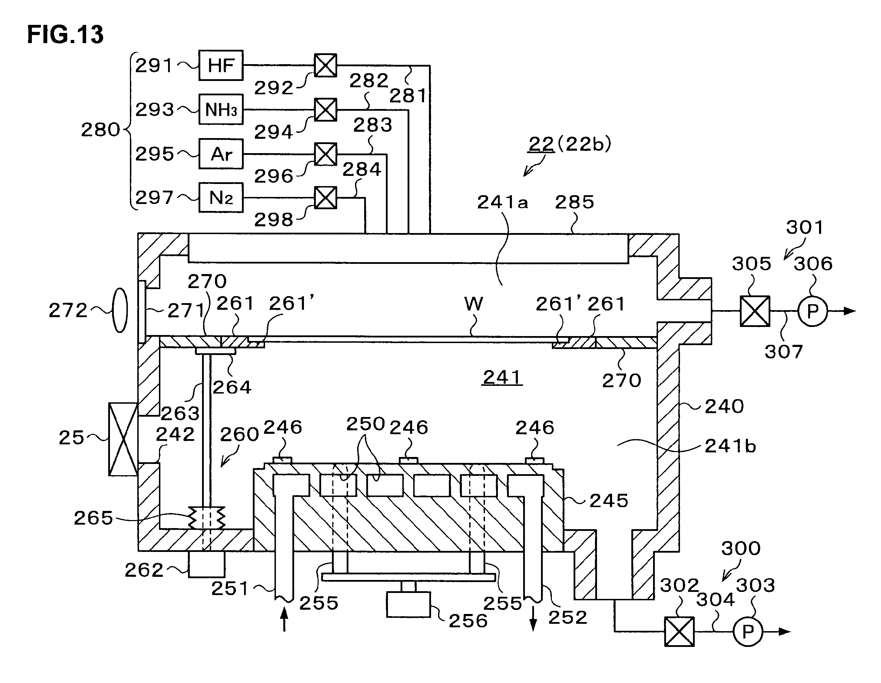

Next, the COR apparatus 22b according to the second embodiment of the present invention will be described. FIG. 12 and FIG. 13 are explanatory views of the COR apparatus 22b according to the second embodiment of the present invention. FIG. 12 shows a state where the wafer W is placed on a mounting table 245 (first processing position). FIG. 13 shows a state where the wafer W is lifted up from the mounting table 245 (second processing position).

The COR apparatus 22b includes a casing 240, and the inside of the casing 240 is an airtight process chamber (processing space) 241 housing the wafer W. The casing 240 is made of metal such as aluminum (Al) or an aluminum alloy which has been surface-treated, for instance, anodized. The casing 240 has on its one side surface a load/unload port 242 through which the wafer W is loaded/unloaded to/from the process chamber 241, and the aforesaid gate valve 25 is provided on the load/unload port 242.

On a bottom of the process chamber 241, a mounting table 245 is provided to have the wafer W placed thereon in a substantially horizontal state. The mounting table 245 functions as a first temperature adjusting member temperature-adjusting the wafer W placed on the mounting table 245. The mounting table 245 has a columnar shape substantially equal in diameter to the wafer W and is made of a material excellent in heat transfer property, for example, metal such as aluminum (Al) or an aluminum alloy.

On an upper surface of the mounting table 245, a plurality of abutting pins 246 as abutting members abutting on a lower surface of the wafer W are provided so as to protrude upward. The abutting pins 246 are made of the same material as that of the mounting table 245 or made of ceramics, resin, or the like. The wafer W is supported substantially horizontally on the upper surface of the mounting table 245 while a plurality of points of its lower surface are set on upper end portions of the abutting pins 246 respectively. For convenience of the description, the position (height) of the wafer W placed on the upper surface of the mounting table 245 as shown in FIG. 12 is defined as a "first processing position".

In the mounting table 245, a refrigerant channel 250 is provided. By circulatingly supplying a refrigerant to the refrigerant channel 250 from the outside of the casing 240 through a refrigerant feed pipe 251 and a refrigerant drain pipe 252, it is possible to cool the mounting table 245 to about 25°C, for instance, and to cool the wafer W placed on the mounting table 245. A refrigerant such as, for example, a fluorine-based inert chemical solution (Galden) is supplied to the refrigerant channel 250.

In the mounting table 245, lifter pins 255 are provided which receive/deliver the wafer W from/to either of the carrier arms 31a, 31b of the aforesaid wafer carrier mechanism 31 when the wafer W is loaded/unloaded. The lifter pins 255 move up/down by the operation of a cylinder device 256 disposed outside the casing 240. When the wafer W is carried into the COR apparatus 22b by either of the carrier arms 31a, 31b of the aforesaid wafer carrier mechanism 31, the lifter pins 255 move up so that the upper ends thereof reach the height of the load/unload port 242 as shown by the dashed line in FIG. 12, to receive the wafer W from the carrier arm 31a, 31b, and thereafter, the lifter pins 255 move down, so that the wafer W is placed on the upper surface of the mounting table 245. Further, when the wafer W is carried out of the COR apparatus 22b, the lifter pins 255 first move up, so that the wafer W is lifted up to the height of the load/unload port 242 as shown by the dashed line in FIG. 12. Thereafter, either of the carrier arms 31a, 31b of the aforesaid wafer carrier mechanism 31 receives the wafer W from the lifter pins 255 to carry the wafer W out of the COR apparatus 22b. For convenience of the description, the position (height) of the wafer W lifted up to the height of the load/unload port 242 by the lifter pins 255 as shown by the dashed line in FIG. 12 is defined as a "load/unload position".

Further, around the wafer W, a lifter mechanism 260 is provided to lift the wafer W placed on the upper surface of the mounting table 245 up to a position still higher than the aforesaid load/unload position. The lifter mechanism 260 is structured such that a ring-shaped support member 261 surrounding an outer side of the wafer W is attached via a bracket 264 to an upper end of a piston rod 263 of the cylinder device 262 disposed outside the casing 240. By the extension/contraction operation of the cylinder device 262, it is possible to change between the state where the wafer W is placed on the mounting table 245 as shown in FIG. 12 and the state where the wafer W is lifted up from the mounting table 245 as shown in FIG. 13. Around the piston rod 263, a bellows 265 is attached to allow the upward/downward movement of the piston rod 263 while keeping the inside of the process chamber 241 airtight.

On an inner side of an upper surface of the support member 261, a stepped portion 261' capable of housing an outer edge portion of the lower surface of the wafer W is formed, and when the piston rod 263 is extended by the operation of the cylinder device 262, the wafer W is lifted up to the position still higher than the load/unload position while the outer edge portion of the lower surface of the wafer W is housed in the stepped portion 261' of the support member 261, as shown in FIG. 13. For convenience of the description, the position (height) of the wafer W lifted up from the upper surface of the mounting table 245 by the lifter mechanism 260 as shown in FIG. 13 is defined as a "second processing position".

On the other hand, when the piston rod 263 is contracted by the operation of the cylinder device 262, the stepped portion 261' of the support member 261 moves down to a position slightly lower than the upper ends of the abutting pins 246 on the upper surface of the mounting table 245, so that the wafer W comes to be supported by the abutting pins 246 on the upper surface of the mounting table 245 (first processing position).

Around the wafer W lifted up to the second processing position by the lifter mechanism 260 as shown in FIG. 13, a partition member 270 is disposed. The partition member 270 is fixed to an inner peripheral surface of the casing 240 and is horizontally disposed so as to partition an area around the support member 261 which has been lifted up to the second processing position while the outer edge portion of the lower surface of the wafer W is housed in the stepped portion 261'. The partition member 270 is made of a heat insulating material such as, for example, VESPEL (registered trademark). When the wafer W is lifted up to the second processing position by the lifter mechanism 260 as shown in FIG. 13, the wafer W, the support member 261, and the partition member 270 partition the inside of the process chamber 241 into a space 241a above the wafer W and a space 241b under the wafer W.

Above the partition member 270, the casing 240 has, on its side surface, a transparent window portion 271. Further, a lamp heater 272 as a second temperature adjusting member is disposed on an outer side of the window portion 271 to emit infrared rays from the outside of the process chamber 241 into the process chamber 241 through the window portion 271. As will be described later, when the wafer W is lifted up to the second processing position by the lifter mechanism 260, the infrared rays are emitted into the process chamber 241 from the lamp heater 272 through the window portion 271, so that the wafer W at the second processing position is heated.

A gas supply mechanism 280 supplying predetermined gases into the process chamber 241 is provided. The gas supply mechanism 280 includes an HF supply path 281 through which hydrogen fluoride gas (HF) as the process gas containing the halogen element is supplied into the process chamber 241, an NH₃ supply path 282 through which ammonia gas (NH₃) as the basic gas is supplied into the process chamber 241, an Ar supply path 283 through which argon gas (Ar) as inert gas is supplied into the process chamber 241, an N₂ supply path 284 through which nitrogen gas (N₂) as inert gas is supplied into the process chamber 241, and a showerhead 285. The HF supply path 281 is connected to a supply source 291 of the hydrogen fluoride gas. Further, the HF supply path 281 has in its middle a flow rate regulating valve 292 capable of opening/closing the HF supply path 281 and adjusting a supply flow rate of the hydrogen fluoride gas. The NH₃ supply path 282 is connected to a supply source 293 of the ammonia gas. Further, the NH₃ supply path 282 has in its middle a flow rate regulating valve 294 capable of opening/closing the ammonia supply path 282 and adjusting a supply flow rate of the ammonia gas. The Ar supply path 283 is connected to a supply source 295 of the argon gas. Further, the Ar supply path 283 has in its middle a flow rate regulating valve 296 capable of opening/closing the Ar supply path 283 and adjusting a supply flow rate of the argon gas. The N₂ supply path 284 is connected to a supply source 297 of the nitrogen gas. Further, the N₂ supply path 284 has in its middle a flow rate regulating valve 298 capable of opening/closing the N₂ supply path 284 and adjusting a supply flow rate of the nitrogen gas. The supply paths 281, 282, 283, 284 are connected to the showerhead 285 provided in a ceiling portion of the process chamber 241, and the hydrogen fluoride gas, the ammonia gas, the argon gas, and the nitrogen gas are diffusively jetted from the showerhead 285 into the process chamber 241.

In the COR apparatus 22b, provided are: a first exhaust mechanism 300 exhausting the inside of the process chamber 241 under the aforesaid partition member 270; and a second exhaust mechanism 301 exhausting the inside of the process chamber 241 above the partition member 270. The first exhaust mechanism 300 includes an exhaust path 304 having in its middle an opening/closing valve 302 and an exhaust pump 303 for forced exhaust. An upstream end portion of the exhaust path 304 is opened at a bottom surface of the casing 240. The second exhaust mechanism 301 includes an exhaust path 307 having in its middle an opening/closing valve 305 and an exhaust pump 306 for forced exhaust. An upstream end portion of the exhaust path 307 is opened at a side surface of the casing 240 above the partition member 270.

In the case of the processing system 1 including the COR apparatuses 22b, the functional elements controlled by the control unit 4 refer to all the elements which operate for realizing predetermined process conditions, for example, the first wafer carrier mechanism 11, the gate valves 14, 25, 26, and the second wafer carrier mechanism 31 which are provided in the processing system 1, and refrigerant supply to the mounting table 245, the cylinder device 256, the lifter mechanism 260, the lamp heater 272, the gas supply mechanism 280, the exhaust mechanisms 300, 301, and so on which are provided in the COR apparatus 22b.

### (Processing of Wafer W in Processing System 1 Including COR Apparatus 22b according to Second Embodiment)

Next, a method of processing the wafer W using the processing system 1 including the COR apparatus 22b according to the second embodiment of the present invention will be described. Similarly to the above description, the following will describe a case, as an example, where natural oxide films 156 formed on the surface of the wafer W having undergone an etching process are removed by the COR processing, and SiGe is epitaxially grown on a surface of a Si layer 150.

In the processing system 1, as shown in FIG. 1, the carrier C housing the plural wafers W is placed on the mounting table 13, and one of the wafers W is taken out of the carrier C by the wafer carrier mechanism 11 to be carried into the load lock chamber 24. When the wafer W is carried into the load lock chamber 24, the load lock chamber 24 is airtightly closed and pressure-reduced. Thereafter, the load lock chamber 24 and the common carrier chamber 21 whose pressure is reduced below the atmospheric pressure are made to communicate with each other. Then, the wafer W is carried out of the load lock chamber 24 to be carried into the common carrier chamber 21 by the wafer carrier mechanism 31.

The wafer W carried into the common carrier chamber 21 is first carried into the process chamber 241 of the COR apparatus 22b. The wafer W is carried into the process chamber 241 of the COR apparatus 22b by either of the carrier arms 31a, 31b of the wafer carrier mechanism 31, with its surface (device formation surface) facing upward. Then, the lifter pins 255 move up and receive the wafer W from the carrier arm 31a, 31b which has lifted up the wafer W to the load/unload position. Thereafter, the lifter pins 255 move down to place the wafer W on the upper surface of the mounting table 245, so that the wafer W is moved to the first processing position as shown in FIG. 12.

After the carrier arm 31a, 31b exits from the inside of the process chamber 241, the load/unload port 242 is closed to make the inside of the process chamber 241 airtight. Incidentally, when the wafer W is thus carried into the process chamber 241, the support member 261 is in a lowered state. Further, the pressure of the process chamber 241 has been reduced to a pressure close to vacuum (for example, several Torr to several tens Torr) by both of the exhaust mechanisms 300, 301 or one of the exhaust mechanisms 300,301.

Then, the refrigerant is circulatingly supplied to the refrigerant channel 250 through the refrigerant feed pipe 251 and the refrigerant drain pipe 252 to cool the mounting table 245 to about 25°C, for instance. In this manner, the wafer W placed on the mounting table 245 is cooled to about 25°C, for instance. In this case, by starting the supply of the refrigerant before the wafer W is placed on the mounting table 245, it is possible to cool the wafer W to a target temperature immediately after the wafer W is placed on the upper surface of the mounting table 245.

Then, the hydrogen fluoride gas, the ammonia gas, the argon gas, and the nitrogen gas are supplied into the process chamber 241 through the respective supply paths 281, 282, 283, 284, and the wafer W at the first processing position is subjected to the chemical processing step for turning the natural oxide films 156 on the surface of the wafer W into the reaction products. In this case, through forced exhaust of the inside of the process chamber 241 by both of the exhaust mechanisms 300, 301 or one of the exhaust mechanisms 300, 301, the pressure in the process chamber 241 is reduced to about several tens mTorr to about several Torr, for instance. In such a low-pressure processing atmosphere, the natural oxide films 156 existing on the surface of the wafer W chemically react with molecules of the hydrogen fluoride gas and molecules of the ammonia gas to be turned into the reaction products.

When the chemical processing step is finished, the supply of the hydrogen fluoride gas and the ammonia gas through the supply paths 281, 282 is stopped. Incidentally, the supply of the argon gas and the nitrogen gas through the supply paths 283, 284 may be stopped at the same time, but the supply of the argon gas and the nitrogen gas into the process chamber 241 through the supply paths 283, 284 may be continued even after the chemical processing step is finished.

Then, the wafer W is moved from the first processing position to the second processing position. Specifically, the piston rod 263 is extended by the operation of the cylinder device 262 of the lifter mechanism 260, so that the wafer W is lifted up to the second processing position while the outer edge portion of the lower surface of the wafer W is housed in the stepped portion 261' of the support member 261 as shown in FIG. 13. Consequently, the wafer W, the support member 261, and the partition member 270 partition the inside of the process chamber 241 into a space 241a above the wafer W and a space 241b under the wafer W. Incidentally, during this transfer of the wafer W from the first processing position to the second processing position, the inside of the process chamber 241 is also forcedly exhausted by both of the exhaust mechanisms 300, 301 or one of the exhaust mechanisms 300, 301 so that the pressure in the process chamber 241 is reduced to about several tens mTorr to about several Torr, for instance.

Next, the PHT step (heat treatment step) is started. In this heat treatment step, the infrared rays are emitted from the lamp heater 272 into the process chamber 241 through the window portion 271 to heat the wafer W at the second processing position to a temperature equal to or higher than about 100°C, for instance. In this case, the wafer W can be rapidly heated to the target temperature since heat capacity of the wafer W itself is relatively small. Incidentally, the emission of the infrared rays by the lamp heater 272 may be started before the wafer W is moved to the second processing position.

Further, during the heat treatment, the upper space 241a in the process chamber 241 is forcedly exhausted by the exhaust mechanism 301 while the argon gas and the nitrogen gas are supplied into the process chamber 241 through the supply paths 283, 284, and reaction products 156' produced by the aforesaid chemical processing are heated and vaporized to be removed from the inner surfaces of the recessed portions 155. In this case, since the inside of the process chamber 241 is partitioned by the wafer W, the support member 261, and the partition member 270 into the upper space 241a and the lower space 241b, the pressure of the upper space 241a is reduced to about several Torr to about several tens Torr, for instance, and the pressure of the lower space 241b is reduced to about several hundreds mTorr to about several Torr, for instance.

Through the above processes, the surface of the Si layer 150 is exposed by the heat treatment (see FIG. 10). Such heat treatment following the chemical processing makes it possible to dry-clean the wafer W and remove the natural oxide films 156 from the Si layer 150 by dry-etching.

When the COR processing including the chemical processing and the heat treatment is finished, the supply of the argon gas and the nitrogen gas is stopped and the load/unload port 242 (gate valve 25) of the COR apparatus 22b is opened. Incidentally, the supply of the argon gas and the nitrogen gas into the process chamber 241 through the supply paths 283, 284 may be continued even after the COR processing is finished.

When the COR processing is finished, the lifter pins 255 move up from the mounting table 245, and the piston rod 263 is contracted by the operation of the cylinder device 262 of the lifter mechanism 260, so that the wafer W is moved down from the second processing position. Then, the wafer W is delivered to the lifter pins 255 from the support member 261 on its way downward. Thus, the wafer W is moved to the load/unload position.

Thereafter, the wafer W is carried out of the process chamber 241 by the wafer carrier mechanism 31, and then carried into the epitaxial growth apparatus 23. Incidentally, when the wafer W is carried out of the process chamber 241, the supply of the argon gas and the nitrogen gas into the process chamber 241 through the supply paths 283, 284 may be continued and the inside of the process chamber 241 may be forcedly exhausted by both of the exhaust mechanisms 300, 301 or one of the exhaust mechanisms 300, 301 so that the pressure in the process chamber 241 is reduced to about several Torr to about several tens Torr, for instance.

When the wafer W with the surface of the Si layer 150 being exposed by the COR processing is thus carried into the epitaxial growth apparatus 23, the SiGe film forming processing is then started. In the film forming processing, reaction gas supplied to the epitaxial growth apparatus 23 and the Si layer 150 exposed in the recessed portions 155 of the wafer W chemically react with each other, so that SiGe layers 160 are epitaxially grown on the recessed portions 155 (see FIG. 11). Here, since the natural oxide films 156 have been removed by the aforesaid COR processing from the surface of the Si layer 150 exposed in the recessed portions 155, the SiGe layers 160 are suitably grown with the surface of the Si layer 150 serving as their base.

When the SiGe layers 160 are thus formed on the recessed portions 155 on the both sides, a portion of the Si layer 150 sandwiched by the SiGe layers 160 is given a compressive stress from both sides. That is, under the Poly-Si layer 152 and the oxide layer 151, a strained Si layer 150' having a compressive strain is formed in the portion sandwiched by the SiGe layers 160.

When the SiGe layers 160 are thus formed, that is, when the film forming processing is finished, the wafer W is carried out of the epitaxial growth apparatus 23 by the wafer carrier mechanism 31 to be carried into the load lock chamber 24. When the wafer W is carried into the load lock chamber 24, the load lock chamber 24 is airtightly closed and thereafter the load lock chamber 24 and the carrier chamber 12 are made to communicate with each other. Then, the wafer W is carried out of the load lock chamber 24 to be returned to the carrier C on the mounting table 13 by the wafer carrier mechanism 11. In the above-described manner, a series of processes in the processing system 1 is finished.

According to the COR apparatus 22b according to the second embodiment of the present invention, in the process chamber 241, the wafer W can be cooled and chemically processed on the mounting table 245 when it is at the first processing position, and the wafer W can be heated by the lamp heater 272 and heat-treated when it is at the second processing position. By thus moving the wafer W to the first processing position and to the second processing position in the process chamber 241, it is possible to rapidly heat and cool the wafer W. This enables rapid heat treatment, which can shorten the processing time to improve a throughput. Further, since the wafer W can be COR-processed in the same process chamber 241, the COR apparatus 22b can be compact and a complicated transfer sequence for transferring the wafer W is not required.

Further, during the heat treatment, the inside of the process chamber 241 is partitioned into the space 241a above the wafer W and the space 241b under the wafer W, and consequently, heat by the lamp heater 272 is not easily transferred to the lower space 241b, which can prevent a temperature increase of the mounting table 245 set in a lower area (an area under the partition member 270) in the process chamber 241. Accordingly, the mounting table 245 is kept in a state where it can easily cool the wafer W placed thereon next. In this case, if the partition member 270 is made of a heat insulating material, it is possible to more effectively prevent the temperature increase of the mounting table 245.

Since the upper space 241a in the process chamber 241 is forcedly exhausted by the exhaust mechanism 301 during the heat treatment, vapor of the reaction products 156' vaporized from the surface of the wafer W can be discharged without entering the lower space 241b, which can prevent the reaction products 156' from adhering again to a rear surface of the wafer W and the lower area in the process chamber 241 (the area under the partition member 270). In this case, the upper area in the process chamber 241 (the area above the partition member 270) becomes higher in temperature than the lower area in the process chamber 241 since the upper area is heated by the lamp heater 272, and therefore the reaction products 156' are difficult to adhere to the upper area. Accordingly, the reaction products 156' do not easily adhere to the entire process chamber 241, which makes it possible to keep the inside of the process chamber 241 clean.

In the foregoing, preferred embodiments of the present invention are described, but the present invention is not limited to such examples. It is obvious that those skilled in the art could think of various modified examples and corrected examples within a range of the technical idea described in the claims, and it is understood that such examples naturally belong to the technical scope of the present invention.

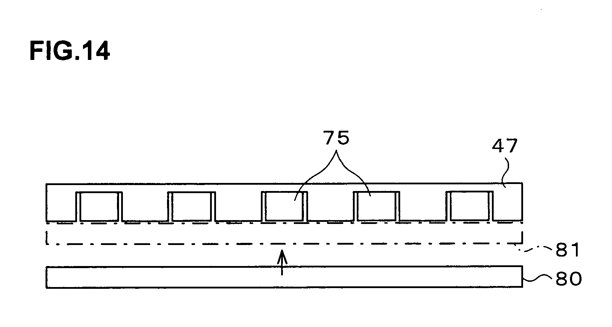

In the COR apparatus 22a according to the first embodiment, the rear surface of the face plate 47 is covered by the heater 75 so that the cold heat of the cooling block 80 is transferred to the face plate 47 via the heater 75, but the cooling block 80 may come into direct contact with the face plate 47. As shown in FIG 14, for instance, in the rear surface of the face plate 47 as the support member, grooves may be provided in which heaters 75 as the first temperature adjusting members are buried, thereby allowing the cooling block 80 as the second temperature adjusting member to come into direct contact with the lower surface of the face plate 47. In this case, the heaters 75 are held with, for example, a metallized stud of the face plate 47 or an adhesive. By the cooling block 80 thus coming into direct contact with the face plate 47, more rapid cooling is possible. Further, depending on the depth and width of the grooves, the contact area of the heaters 75 and the face plate 47 can be increased, which can realize more rapid temperature increase. Further, for improved heat transfer efficiency to the face plate 47, the upper surface of the cooling block 80 may be coated with grease, gelatinous substance, or the like high in heat transfer property. Further, a sheet or the like with a high heat transfer property may be provided on the upper surface of the cooling block 80. Further, for decreased thermal resistance between the heaters 75 and the face plate 47, a filler such as an adhesive or a heat transfer material may be provided between the heaters 75 and the face plate 47.

In the COR apparatus 22b according to the second embodiment, the mounting table 245 including the refrigerant channel 250 is shown as an example of the first temperature adjusting member, and the lamp heater 272 is shown as an example of the second temperature adjusting member. However, as these first and second temperature adjusting mechanisms, any temperature adjusting mechanisms capable of heating or cooling can be used. In particular, the second temperature adjusting mechanism may be a heating mechanism provided in the middle of the N₂ supply path 284 in order to increase the temperature of the nitrogen gas. The nitrogen gas whose temperature has been increased may be jetted to the upper space 241a of the process chamber 241 from the showerhead 285 to heat the wafer W. Further, a heating mechanism may be provided in the Ar supply path 283. Further, the wafer W may be heated by the combination of the lamp heater 272 described in the above embodiment and the above heating mechanism.

## Claims

1. A substrate processing apparatus removing an oxide film on a surface of a substrate by chemical processing and heat treatment, the apparatus comprising:
a gas supply mechanism supplying gas containing a halogen element and basic gas into a process chamber; and
a first temperature adjusting member and a second temperature adjusting member adjusting a temperature of the substrate in the process chamber,
wherein said second temperature adjusting member adjusts the temperature of the substrate to a higher temperature than said first temperature adjusting member.

2. The substrate processing apparatus according to claim 1,
wherein the inside of the process chamber is airtightly closable.

3. The substrate processing apparatus according to claim 1, further comprising
an exhaust mechanism exhausting the inside of the process chamber.

4. The substrate processing apparatus according to claim 1, further comprising
a support member supporting the substrate in the process chamber,
wherein said second temperature adjusting member is thermally in contact with said support member, and said first temperature adjusting member is capable of thermally coming into contact with and separating from said support member.

5. The substrate processing apparatus according to claim 4,
wherein a rear surface of said support member is exposed to an external part of the process chamber, and said first temperature adjusting member is capable of thermally coming into contact with or separating from the rear surface of said support member, in the external part of the process chamber.

6. The substrate processing apparatus according to claim 4,
wherein a rear surface of said support member is covered by said second temperature adjusting member, and said first temperature adjusting member comes into contact with said second temperature adjusting member.

7. The substrate processing apparatus according to claim 4,
wherein said second temperature adjusting member is buried in said support member, and said first temperature adjusting member comes into contact with said support member.

8. The substrate processing apparatus according to claim 4,
wherein total heat capacity of said support member and said second temperature adjusting member is smaller than heat capacity of said first temperature adjusting member.

9. The substrate processing apparatus according to claim 1,
wherein said first temperature adjusting member is a mounting table on which the substrate is placed in the process chamber, and the apparatus further comprising
a lifter mechanism lifting up the substrate from the mounting table in the process chamber,
wherein the temperature of the substrate which has been lifted up from said mounting table by said lifter mechanism is adjusted by said second temperature adjusting member.

10. The substrate processing apparatus according to claim 9, further comprising
a partition member disposed around the substrate which has been lifted up from said mounting table by said lifter mechanism;
a first exhaust mechanism exhausting the inside of the process chamber above said partition member; and
a second exhaust mechanism exhausting the inside of the process chamber under said partition member.

11. The substrate processing apparatus according to claim 9,
wherein said gas supply mechanism supplies the gas containing the halogen element and the basic gas to the inside of the process chamber above the substrate which has been lifted up from said mounting table by said lifter mechanism.

12. A substrate processing method of removing an oxide film on a surface of a substrate by chemical processing and heat treatment, the method comprising the steps of:
supplying gas containing a halogen element and basic gas to the inside of a process chamber and adjusting a temperature of the substrate by a first temperature adjusting member, thereby turning the oxide film on the surface of the substrate into a reaction product; and
adjusting the temperature of the substrate to a higher temperature by the second temperature adjusting member than the first temperature adjusting member, thereby vaporizing the reaction product.

13. The substrate processing method according to claim 12,
wherein the inside of the process chamber is exhausted.

14. The substrate processing method according to claim 12,
wherein the substrate is supported by a support member including the second temperature adjusting member, and
wherein, in said step of turning the oxide film on the surface of the substrate into the reaction product, the first temperature adjusting member is brought into thermal contact with the support member, and
wherein, in said step of vaporizing the reaction product, the first temperature adjusting member is thermally separated from the support member.

15. The substrate processing method according to claim 14,
wherein the first temperature adjusting member is thermally brought into contact with or separated from the support member, in an external part of the process chamber.

16. The substrate processing method according to claim 14,
wherein total heat capacity of the support member and the second temperature adjusting member is smaller than heat capacity of the first temperature adjusting member.

17. The substrate processing method according to claim 12,
wherein, in said step of turning the oxide film on the surface of the substrate into the reaction product, the temperature of the substrate is adjusted while the substrate is placed on a mounting table as the first temperature adjusting member, and
wherein, in said step of vaporizing the reaction product, the temperature of the substrate is adjusted by the second temperature adjusting member while the substrate is lifted up from the mounting table in the process chamber.

18. A storage medium containing a recorded program executable by a control unit of a substrate processing apparatus,
the program causing the substrate processing apparatus to perform the substrate processing method according to claim 12 when executed by the control unit.
